**Europäisches Patentamt**

**European Patent Office**

**Office européen des brevets**

(19)

(11) Veröffentlichungsnummer: **0 166 973**

**B1**

(12)

# EUROPÄISCHE PATENTSCHRIFT

(45) Veröffentlichungstag der Patentschrifft:
**17.01.90**

(21) Anmeldenummer: **85106691.0**

(22) Anmeldetag: **30.05.85**

(51) Int. Cl. ⁴: **H 03 G   1/00**

(54) **Differenzverstärkerschaltung.**

(30) Priorität: **07.06.84 DE 3421241**

(43) Veröffentlichungstag der Anmeldung:
**08.01.86 Patentblatt 86/02**

(45) Bekanntmachung des Hinweises auf die Patenterteilung:
**17.01.90 Patentblatt 90/03**

(84) Bennante Vertragsstaaten:
**AT BE CH DE FR GB IT LI NL SE**

(56) Entgegenhaltungen:
**DE-A-1 902 064**
**FR-A-2 376 557**
**GB-A-1 320 910**
**GB-A-2 010 616**
**US-A-3 512 096**
**US-A-3 846 712**
**US-A-4 286 226**

(73) Patentinhaber: **Siemens Aktiengesellschaft**
**Wittelsbacherplatz 2**
**D-8000 München 2 (DE)**

(72) Erfinder: **Fenk, Josef, Dipl.-Ing.**
**Deutenhauserstrasse 10**
**D-8057 Eching/Ottenburg (DE)**

LIBERGRAF, STOCKHOLM 1990

2

Beschreibung

Die vorliegende Erfindung betrifft eine Differenzverstärkerschaltung nach dem Oberbegriff des Patentanspruchs 1.

Eine Differenzverstärkerschaltung der gattungsgemäßen Art ist aus der DE-A-3 204 430 bekannt. Dabei handelt es sich um eine Differenzverstärkerschaltung, die bis in den UHF-Bereich hinein eine maximale Signalverstärkung bei großem Verstärkungsregelumfang gewährleistet. Die Schaltungsanordnung ist dabei so getroffen, daß sowohl eine das Eingangssignal aufnehmende Differenzverstärkerstufe als auch weitere von einem Verstärkungsregelsignal ange-steuerte Differenzverstärkerstufen auf gemeinsa-me Ausgangsknoten arbeiten und so den Arbeitspunkt stabilisieren. Die Ausgangsknoten werden dabei durch nachgeschaltete Kaskode-Stufen vom Ausgang entkoppelt.

Dabei ergeben sich jedoch entweder noch unerwünschte Rückkopplungen auf den Signalweg oder aber es ist eine Verwendung von Mehremitter-Transistoren erforderlich, die insbesondere für Hochfrequenzverstärker nicht optimal sind. Weiterhin bedingen auch die vorgenannten Kaskode-Stufen unerwünschte Phasendrehungen.

Weiterhin sind gattungsgemäße Differenzverstärkerschaltungen aus den Patentschriften US-A-4 286 226 und US-A-3 512 096 bekannt. In der US-A-4 286 226 sind die beiden Ausgangsklemmen über Widerstände in einem Summations-punkt zusammengefaßt und eine Arbeitspunktre-gelung erfolgt hierbei für beide Differenzver-stärkerpfade gleichzeitig. Eine getrennte Arbeits-punktregelung für die einzelnen Differenzverstär-kerpfade ist nicht möglich. In diesem besagten Summationspunkt wird das Differenzsignal für hohe Frequenzen ausgelöscht, so daß bei solchen Schaltungen für hohe Frequenzen keine unterstützende Wirkung für die Hochfrequenzverstärkung erzielbar ist. Aus der US-A-3 512 096 ist insbesondere in Figur 9 eine Differenzverstärkerschaltung bekannt, bei der eine Regelstufe zur Regelung der Arbeitspunkte vorgesehen ist. Hierzu sind die beiden Ausgänge des Differenzverstärkers jeweils über einen Widerstand mit dem Emitter eines Regelstufentransistors verbunden, dessen Kollektor jeweils an das Versor-gungspotential angeschlossen ist. Die Basisan-schlüsse dieser Regelstufentransistoren sind zu-sammengeschaltet und werden gemeinsam an-gesteuert. Durch die über die dynamischen Widerstände der Basis-Emitter-Dioden dieser beiden Regelstufentransistoren gegebene niederohmige, stromverteilungsabhängige Koppelung des rechten und des linken Strompfades tritt hierbei eine Gegenkoppelung für hohe Frequen-zen auf. Deshalb ermöglicht eine solche Regelstufe nicht die Realisierung einer Differenzverstärkerschaltung, bei der die unterstützende Wirkung der Regelstufe auf die Hochfrequenzver-stärkung der Differenzverstärkerschaltung erhal-ten bleibt. Somit gibt weder die US-A-4 286 226 noch die US-A-3 512 096 eine Anleitung zur Realisierung einer Differenzverstärkerstufe, bei der die Arbeitspunkte der Verstärkerausgänge auch im oberen Frequenzbereich arbeitspunkt- und verstärkungsunabhängig außerhalb des Signalweges des Verstärkers eingestellt werden können.

Der vorliegenden Erfindung liegt die Aufgabe zugrunde, eine Möglichkeit anzugeben, mit der die Arbeitspunkte von Verstärkerausgängen ar-beitspunkt- und verstärkungsunabhängig außer-halb des Signalwegs des Verstärkers eingestellt werden können.

Diese Aufgabe wird bei einer Differenzverstärkerschaltung der eingangs genannten Art erfindungsgemäß durch die Merkmale des kennzeichnenden Teils des Patentanspruchs 1 gelöst.

Weiterbildungen des Erfindungsgedankens sind in Unteransprüchen gekennzeichnet.

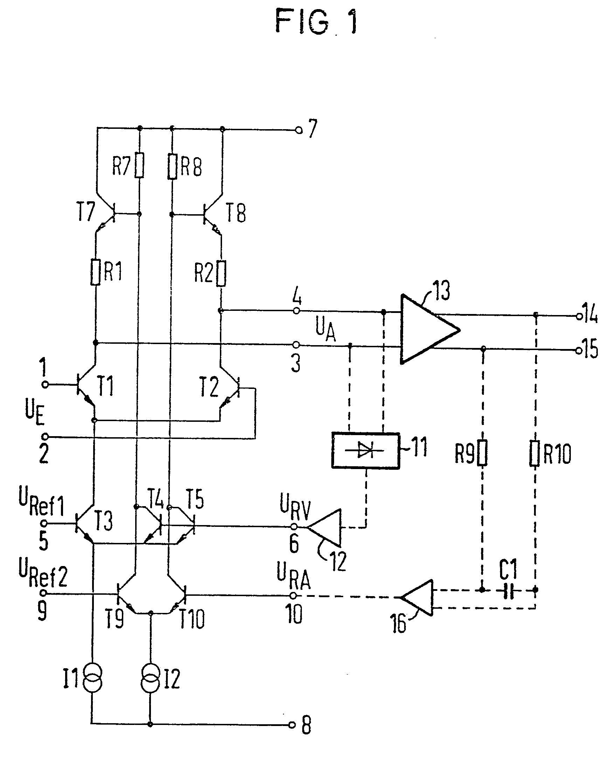

Die Erfindung wird im folgenden anhand von dem in Figur 1 dargestellten Ausführungsbeispielen näher erläutert.

Die Differenzverstärkerschaltung gemäß Figur 1 besitzt eine erste durch Transistoren T1 und T2 gebildete Differenzverstärkerstufe mit Eingängen 1 und 2, welche einen symmetrischen Schaltungseingang bilden und ein Eingangssignal $U_E$ aufnehmen. In den Ausgangskreisen der Transistoren T1 und T2, d. h. in deren Kollektorzweigen, liegen Arbeitswiderstände R1 und R2, an denen ein Ausgangssignal der Differenzverstär-kerschaltung abnehmbar ist. Die Verbindungs-punkte der Arbeitswiderstände R1 und R2 sowie der Kollektoren der Transistoren T1 und T2 bilden also einen Ausgang 3, 4 der Differenzverstärkerschaltung, an dem das mit $U_A$ bezeichnete Ausgangssignal abnehmbar ist.

Die Differenzverstärkerschaltung weist weitere Differenzverstärkerstufen auf, die durch Transistoren T3 und T4 bzw. T3 und T5 gebildet werden. Diese weiteren Differenzverstärkerstufen sind derart geschaltet, daß der Ausgangskreis des Transistors T3, d. h. dessen Kollektor-Emitter-Strecke, mit den direkt miteinander verbundenen Emittern der Transistoren T1 und T2 zusammengeschaltet ist. Die Ausgangskreise, d. h. die Kollektor-Emitter-Strecken der Transistoren T4 und T5 sind in im folgenden noch genauer zu beschreibender Weise mit einer im Kreis der Arbeitswiderstände R1 und R2 liegenden Regelstufe gekoppelt. Die Emitter der Transistoren T3 bis T5 sind, wie bei Differenzverstärkerstufen üblich, direkt miteinander verbunden und werden von einer Stromquelle I1 gespeist.

Es ist andererseits auch möglich, die Emitter der genannten Differenzverstärkerstufen über Widerstände zu koppeln, um die Eingangskennli-nienlänge dieser Differenzverstärkerstufen festzu-legen.

Die genannten Differenzverstärkerstufen T3 bis T5 liegen in einem Verstärkungsregelkreis, der durch einen am Ausgang 3, 4 liegenden Gleichrichter 11 und einen Amplitudenregelverstärker 12 gebildet wird, wobei in die Basen der Transistoren T4 und T5 vom Ausgang des Verstärkers 12 an einer Klemme 6 ein Verstärkungs-

3

regelsignal $U_{RV}$ eingespeist wird. In die Basis des Transistors T3 wird an einer Klemme 5 ein Referenzsignal $U_{Ref1}$ für die Verstärkungsregelung eingespeist.

Die Differenzverstärkerschaltung besitzt weiterhin eine zur Arbeitspunktregelung dienende Differenzverstärkerstufe mit Transistoren T9 und T10, deren miteinander verbundene Emitter von einer Stromquelle I2 gespeist werden. Die Ausgangskreise, d. h. die Kollektor-Emitter-Strecken der Transistoren T9 und T10 dieser Differenzverstärkerstufe sind den Ausgangskreisen der Transistoren T4 und T5 der Differenzverstärkerstufen für die Verstärkungsregelung parallelgeschaltet.

Die letztgenannte, durch die Transistoren T9 und T10 gebildete Differenzverstärkerstufe liegt in einem Arbeitspunktregelkreis, der durch einen am Ausgang 3, 4 liegenden Nachfolgeverstärker 13, einen an dessen Ausgang liegenden Tiefpaß R9, R10, C1 sowie einen Arbeitspunktregelverstärker 16 gebildet wird, wobei vom Ausgang dieses Verstärkers 16 an einer Klemme 10 ein Arbeitspunktregelsignal $U_{RA}$ in die Basis des Transistors T10 eingespeist wird. In die Basis des Transistors T9 wird an einer Klemme 9 ein Referenzsignal $U_{Ref2}$ eingespeist. An dem mit 14, 15 bezeichneten Ausgang des Nachfolgeverstärkers 13 ist das weiter verstärkte Ausgangssignal $U_A$ des Ausgangs 3, 4 der Differenzverstärkerschaltung abnehmbar.

Die Differenzverstärkerschaltung wird an Klemmen 7 und 8 mit einer Versorgungsspannung gespeist, wobei üblicherweise die Klemme 7 das Versorgungspotential und die Klemme 8 Bezugspotential (Masse) führt. Bei Verwendung von Transistoren anderen Leitungstyps in der Differenzverstärkerschaltung kehren sich die Potentialverhältnisse natürlich entsprechend im.

Erfindungsgemäß liegt nun im Kreis der Arbeitswiderstände R1 und R2 eine Regelstufe, welche durch Transistoren T7, T8 sowie Widerstände R7 und R8 gebildet wird. Speziell liegen die Ausgangskreise, d. h. die Kollektor-Emitter-Strecken der Transistoren T7 und T8 in Reihe zu den Arbeitswiderstanden R1 und R2, während die Widerstände R7 und R8 in den Ausgangskreisen, d. h. in den den Kollektor-Emitter-Strecken der Transistoren T4 und T5 bzw. T9 und T10 der Verstärkungsregel-Differenzverstärkerstufen bzw. der Arbeitspunktregel-Differenzverstärkerstufe liegen. Der Verbindungspunkt der Kollektoren der Transistoren T4 und T5 bzw. T9 und T10 sowie der Widerstände R7 und R8 liegt an den Basen der Transistoren T7 und T8. Auf der von den Arbeitswiderständen R1 und R2 abgewandten Seite liegen die Kollektoren der Transistoren T7 und T8 sowie ein Anschluß der Widerstände R7 und R8 an der Versorgungsspannungsklemme 7.

Die vorstehend beschriebene Differenzverstärkerschaltung eignet sich insbesondere für eine Hochfrequenzverstärkung bis in den UHF-Bereich, da zwischen dem Eingang 1, 2 und dem Ausgang 3, 4 lediglich die eigentliche Differenzverstärkerstufe T1, T2 liegt und daher kurze Signalwege gegeben sind.

4

Bei maximaler Verstärkung, d. h. wenn das Basispotential der Transistoren T4 und T5 negativer als das Basispotential des Transistors T3 ist, fließt der gesamte Strom der Stromquelle I1 über die Kollektor-Emitter-Strecke des Transistors T3 in die Emitter der Differenzverstärkerstufe T1, T2. Das verstärkte Eingangssignal $U_E$ liegt an den Kollektoren der Transistoren T1 und T2 und den zugehörigen Arbeitswiderständen R1 und R2. Das Potential am Ausgang 3, 4 gegen Bezugspotential ist dann durch folgende Beziehungen gegeben.

$$U_{3/8\ Vmax} = U_7 - R7 \left(\frac{I1}{2 \cdot B_7} + \frac{I2}{2}\right) - U_{be7} - R1 \cdot \frac{I1}{2}$$

$$U_{4/8\ Vmax} = U_7 - R8 \left(\frac{I1}{2 \cdot B_8} + \frac{I2}{2}\right) - U_{be8} - R2 \cdot \frac{I1}{2}$$

Darin bedeuten.

$U_7$     das Versorgungspotential an der Klemme 7,

$I1$     der aus der Stromquelle I1 in die Differenzverstärkerstufe T1, T2 fließende Strom,

$I2$     der aus der Stromquelle I2 der über die Arbeitspunktregel-Differenzverstärkerstufe T9, T10 in die Regelstufe fließende Strom,

$B_7$, $B_8$     die Stromverstärkung des Transistors T7 bzw. T8, und

$U_{be7}$, $U_{be8}$     die Basis-Emitter-Schwellspannung des Transistors T7 bzw. T8.

Bei minimaler Verstärkung ist das Basispotential an den Transistoren T4 und T5 positiver als das Basispotential am Transistor T3, so daß dann der gesamte Strom der Stromquelle I1 über die Emitter-Kollektorstrecken der Transistoren T4 und T5 in die Widerstände R7 und R8 der Regelstufe fließt. Die Widerstände R7 und R8 sind insbesondere untereinander gleich und gleich den Arbeitswiderständen R1 und R2. Das Potential am Ausgang 3, 4 gegen Bezugspotential ist dann durch folgende Beziehungen gegeben:

$$U_{3/8\ Vmin} = U_7 - R7 \left(\frac{I1}{2} + \frac{I2}{2}\right) - U_{be7}$$

$$U_{4/8\ Vmin} = U_7 - R8 \left(\frac{I1}{2} + \frac{I2}{2}\right) - U_{be8}$$

Aus den vorstehenden Gleichungen ist ersichtlich, daß bei maximaler Verstärkung das Potential am Ausgang 3, 4 um die Größe

$$\Delta U_{3(4)/8\ Vmax} = R7\,(8) \cdot \frac{I1}{2 \cdot B_{7(8)}}$$

kleiner ist als bei minimaler Verstärkung. Da die Stromverstärkungen $B_7$, $B_8$ sehr groß sind, ist diese Abweichung vernachlässigbar klein, d. h. der Gleichspannungspegel am Ausgang 3, 4 ist praktisch konstant.

Über die oben bereits erläuterte Arbeitspunktregelung mittels des Arbeitspunktregelsignals U$_{RA}$ an der Klemme 10 ist der statische Offset an den Klemmen 14 und 15 auf minimale Werte einstellbar.

Die vorstehend erläuterte Differenzverstärkerschaltung besitzt den wesentlichen Vorteil, daß durch die Regelstufe T7, T8; R7, R8 lediglich in den durch die Differenzverstärkerstufe T1 und T2 sowie die Arbeitswiderstände R1 und R2 gebildeten Gleichspannungskreis eingegriffen wird, um die Verstärkungs- bzw. Arbeitspunkteinstellung zu realisieren. Der Hochfrequenzsignalweg kann dabei hinsichtlich parasitärer Elemente optimiert werden.

**Patentansprüche**

1. Differenzverstärkerschaltung mit einer ersten, durch ein Transistorpaar (T1, T2) gebildeten Differenzverstärkerstufe, deren Eingänge (1, 2) den Schaltungseingang bilden, mit einem Schaltungsausgang (3,4) an Arbeitswiderständen (R1, R2) in den Ausgangskreisen der Transistoren (T1, T2) der ersten Differenzverstärkerstufe und mit mindestens zwei weiteren Differenzverstärkerstufen (T3 bis T5), die jeweils einen Referenz- und einen Verstärkungsregeleingang (5 bzw. 6) besitzen und die mindestens mit ihrem am Referenzeingang (5) liegenden Kreis (T3) in den Ausgangskreisen der Transistoren (T1, T2) der ersten Differenzverstärkerstufe liegen, *dadurch gekennzeichnet,* daß eine in den Kreisen der Arbeitswiderstände (R1, R2) liegende Regelstufe (R7, R8, T7, T8) vorgesehen ist, die zwei Regeltransistorzweige (T7, T8) und zwei Widerstandszweige (R7, R8) enhält, daß jeweils ein Ausgangskreis eines Regeltransistors (T7 bzw. T8) im Kreis jeweils eines Arbeitswiderstandes (R1 bzw. R2) liegt, daß sich jeweils ein Widerstand (R7 bzw. R8) jeweils im Ausgangskreis der am Verstärkungsregeleingang (6) liegenden Transistoren (T4, T5) der weiteren Differenzverstärkerstufe (T3 bis T5) befindet, daß jeweils der Eingang der Regeltransistoren (T7, T8) jeweils am Verbindungspunkt der Widerstände (R7, R8) und der Ausgangskreise der am Verstärkungsregeleingang (6) liegenden Transistoren (T4, T5) der weiteren Differenzverstärkerstufen (T3 bis T5) liegt und die Regeltransistoren (T7, T8) im Sinne einer Konstanthaltung des Gleichspannungspegels am Schaltungsausgang (3, 4) angesteuert sind.

2. Differenzverstärkerschaltung nach Anspruch 1 *dadurch gekennzeichnet,* daß die weiteren Differenzverstärkerstufen (T3 bis T5) einen gemeinsamen am Referenzeingang (5) und in den miteinander gekoppelten Emitterzweigen der Transistoren (T1, T2) liegenden Transistor (T3) sowie jeweils einen am Verstärkungsregeleingang (6) liegenden Transistor (T4 bzw. T5) enthalten.

3. Differenzverstärkerschaltung nach einem der Ansprüche 1 bis 2, *dadurch gekennzeichnet,* daß der Schaltungsausgang (3, 4) über einen Gleichrichter (11) und einen Regelverstärker (12) auf den Verstärkungsregeleingang (6) gekoppelt ist.

4. Differenzverstärkerschaltung nach einem der Ansprüche 1 bis 3, *gekennzeichnet durch* eine Differenzverstärkerstufe zur Arbeitspunktregelung mit einem Transistorpaar (T9, T10), deren Ausgangskreise den Ausgangskreisen der am Verstärkungsregeleingang (6) liegenden Transistoren (T4, T5) der weiteren Differenzverstärkerstufen (T3 bis T5) parallelgeschaltet sind, wobei einer der Transistoren (T9) mit seinem Eingang an einem weiteren Referenzeingang (9) und der andere der Transistoren (T10) an einem Arbeitspunktregeleingang (10) liegt.

5. Differenzverstärkerschaltung nach Anspruch 4, *dadurch gekennzeichnet,* daß der Schaltungsausgang (3, 4) auf den Arbeitspunktregeleingang (10) gekoppelt ist.

6. Differenzverstärkerschaltung nach Anspruch 1, *dadurch gekennzeichnet,* daß jeweils ein Ausgangskreis eines Regeltransistors (T7 bzw. T8) im Kreis jeweils eines Arbeitswiderstandes (R1 bzw. R2) liegt, daß sich jeweils ein Widerstand (R7 bzw. R8) jeweils im Ausgangskreis der am Verstärkungsregeleingang (6) liegenden Transistoren (T4, T5) der weiteren Differenzverstärkerstufen (T3 bis T5) befindet und daß der Eingang der Regeltransistoren (T7, T8) am Verbindungspunkt der Widerstände (R7, R8) und der Ausgangskreise der am Verstärkungsregeleingang (6) liegenden Transistoren (T4, T5) der weiteren Differenzverstärkerstufen (T3 bis T6) liegt.

7. Differenzverstärkerschaltung nach einem der Ansprüche 1 bis 6, *dadurch gekennzeichnet,* daß die Widerstände (R7, R8) der Regelstufe (R7, R8, T7, T8) einander gleich und gleich den Arbeitswiderständen (R1, R2) sind.

**Claims**

1. Differential amplifier circuit comprising a first differential amplifier stage which is formed by a transistor pair (T1, T2), the inputs of which (1, 2) form the circuit input, with a circuit output (3, 4) across load resistors (R1, R2) in the output circuits of the transistors (T1, T2) of the first differential amplifier stage and comprising at least two further differential amplifier stages (T3 to T5) which in each case have a reference and a gain control input (5 and 6, respectively) and which are located at least with their circuit (T3) located at the reference input (5) in the output circuits of the transistors (T1, T2) of the first differential amplifier stage, characterized in that a control stage (R7, R8, T7, T8), which is located in the circuits of the load resistors (R1, R2), is provided which contains two control transistor branches (T7, T8) and two resistor branches (R7, R8), in that in each case an output circuit of a control transistor (T7 and T8, respectively) is located in the circuit of in each case one load resistor (R1 and R2, respectively), in that in each case one resistor (R7 and R8, respectively) is in each case located in the output circuit of the transistors (T4, T5), located at the gain control input (6), of the further differential amplifier stage (T3 to T5), in that in each case the input of the control transistors (T7, T8) is in each case located at the junction of the resistors (R7, R8) and of the output circuits of the transistors (T4, T5), located at the gain control input (6), of the further differential amplifier stages (T3 to T5), and the control transistors (T7, T8) are driven in the sense of keeping the direct voltage level constant at the circuit output (3, 4).

2. Differential amplifier circuit according to Claim 1, characterized in that the further differential amplifier stages (T3 to T5) contain a common transistor (T3) which is located at the reference input (5) and in the emitter branches, coupled to one another, of the transistors (T1, T2) and in each case contain a transistor (T4 and T5, respectively) which is located at the gain control input (6).

3. Differential amplifier circuit according to one of Claims 1 to 2, characterized in that the circuit output (3, 4) is coupled via a rectifier (11) and a control amplifier (12) to the gain control input (6).

4. Differential amplifier circuit according to one of Claims 1 to 3, characterized by a differential amplifier stage for controlling the operating point with a transistor pair (T9, T10), the output circuits of which are connected in parallel with the output circuits of the transistors (T4, T5), located at the gain control input (6), of the further differential amplifier stages (T3 to T5), one of the transistors (T9) being located with its input at a further reference input (9) and the other one of the transistors (T10) being located at an operating point control input (10).

5. Differential amplifier circuit according to Claim 4, characterized in that the circuit output (3, 4) is coupled to the operating point control input (10).

6. Differential amplifier circuit according to Claim 1, characterized in that in each case one output circuit of a control transistor (T7 and T8, respectively) is located in the circuit of in each case one load resistor (R1 and R2), in that in each case one resistor (R7 and R8, respectively) is in each case located in the output circuit of the transistors (T4, T5), located at the gain control input (6), of the further differential amplifier stages (T3 to T5), and in that the input of the control transistors (T7, T8) is located at the junction of the resistors (R7, R8) and of the output circuits of the transistors (T4, T5), located at the gain control input (6), of the further differential amplifier stages (T3 to T5).

7. Differential amplifier circuit according to one of Claims 1 to 6, characterized in that the resistors (R7, R8) of the control stage (R7, R8, T7, T8) are equal to one another and equal to the load resistors (R1, R2).

**Revendications**

1. Montage amplificateur différentiel comprenant un premier étage amplificateur différentiel formé par une paire de transistors (T1, T2) dont les entrées (1, 2) constituent l'entrée du montage, une sortie (3, 4) du montage, sur des résistances de charge (R1, R2) dans les circuits de sortie des transistors (T1, T2) du premier étage amplificateur différentiel, ainsi qu'au moins deux étages amplificateurs différentiels supplémentaires (T3 à T5) qui possèdent l'un une entrée de référence (5) et l'autre une entrée de réglage d'amplification (6) et qui sont disposés, au moins par leur circuit (T3) connecté à l'entrée de référence (5), dans les circuits de sortie des transistors (T1, T2) du premier étage amplificateur différentiel, caractérisé en ce qu'il comporte un étage de réglage (R7, R8, T7, T8) compris dans les circuits des résistances de charge (R1, R2) et qui contient deux branches à transistor de réglage (T7, T8) et deux branches à résistance (R7, R8), qu'un circuit de sortie d'un transistor de réglage (T7 ou T8) est compris chaque fois dans le circuit d'une résistance de charge (R1 ou R2), qu'une résistance (R7 ou R8) est contenue chaque fois dans le circuit de sortie des transistors (T4, T5) connectés à l'entrée (6) de réglage de l'amplification des étages amplificateurs différentiels supplémentaires (T3 à T5), que l'entrée des transistors de réglage (T7, T8) est reliée au point de connexion des résistances (R7, R8) et des circuits de sortie des transistors (T4, T5), reliés à l'entrée (6) de réglage de l'amplification, des étages amplificateurs différentiels supplémentaires (T3 à T5) et que les transistors de réglage (T7, T8) sont attaqués dans le sens du maintien du niveau de la tension continue sur la sortie (3, 4) du montage à une valeur constante.

2. Montage amplificateur différentiel selon la revendication 1, caractérisé en ce que les étages amplificateurs différentiels supplémentaires (T3 à T5) possèdent un transistor commun (T3) relié à l'entrée de référence (5) et contenu dans les branches d'émetteur, couplées entre elles, des transistors (T1, T2), ainsi que, respectivement, un transistor (T4 ou T5) relié à l'entrée (6) de réglage de l'amplification.

3. Montage amplificateur différentiel selon la revendication 1 ou 2, caractérisé en ce que la sortie (3, 4) du montage est couplée, à travers un redresseur (11) et un amplificateur de réglage (12), à l'entrée (6) de réglage de l'amplification.

4. Montage amplificateur différentiel selon une des revendications 1 à 3, caractérisé par un étage amplificateur différentiel pour le réglage du point de fonctionnement, comprenant une paire de transistors (T9, T10) dont les circuits de sortie sont connectés en parallèle avec les circuits de sortie des transistors (T4, T5), reliés à l'entrée (6) de réglage de l'amplification, des étages amplificateurs différentiels supplémentaires (T3 à T5), l'un des transistors (T9) de ladite paire étant relié par son entrée à une entrée de référence supplémentaire (9) et l'autre transistor (T10) de la paire étant relié à une entrée (10) de réglage du point de fonctionnement.

5. Montage amplificateur différentiel selon la revendication 4, caractérisé en ce que la sortie (3, 4) du montage est couplée à l'entrée (10) de réglage du point de fonctionnement.

6. Montage amplificateur différentiel selon la revendication 1, caractérisé en ce qu'un circuit de sortie d'un transistor de réglage (T7 ou T8) se trouve chaque fois dans le circuit d'une résistance de charge (R1 ou R2), qu'une résistance (R7 ou R8) est contenue chaque fois dans le circuit de sortie des transistors (T4, T5), reliés à l'entrée (6) de réglage de l'amplification, des étages amplificateurs différentiels supplémentaires (T3 à T5) et que l'entrée des transistors de réglage (T7, T8) est reliée au point de connexion des résistances (R7, R8) et des circuits de sortie des transistors (T4, T5), reliés à l'entrée (6) de réglage de l'amplification, des étages amplificateurs différentiels supplémentaires (T3 à T5).

7. Montage amplificateur différentiel selon une des revendications 1 à 6, caractérisé en ce que les résistances (R7, R8) de l'étage de réglage (R7, R8, T7, T8) sont identiques entre elles et aux résistances de charge (R1, R2).

# FIG. 1